(19) Europäisches Patentamt
European Patent Office
Office européen des brevets

(11) EP 2 592 117 A1

(12) EUROPEAN PATENT APPLICATION

(43) Date of publication:
15.05.2013 Bulletin 2013/20

(51) Int Cl.:
C08L 77/06 (2006.01)    C08G 69/26 (2006.01)
H01L 33/48 (2010.01)    H01L 33/60 (2010.01)
C08K 3/22 (2006.01)    C08K 3/30 (2006.01)

(21) Application number: 11188632.1

(22) Date of filing: 10.11.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Solvay Specialty Polymers USA, LLC.
Alpharetta, GA 30005-3914 (US)

(72) Inventors:
• Bushelman, Corinne
Cumming, GA Georgia 30040 (US)
• Singletary, Nancy J.
Alpharetta, GA Georgia 30004 (US)

(74) Representative: Benvenuti, Federica et al
SOLVAY SA
Intellectual Assets Management
Rue de Ransbeek, 310
1120 Bruxelles (BE)

(54) **Polyamide composition and article manufactured therefrom**

(57) An aromatic polyamide composition [composition (C)] comprising :
(i) an aromatic polyamide polymer [polyamide (A)] comprising recurring units derived from
- a carboxylic acid [acid component (AA)], comprising :
(a) at least one dicarboxylic acid or derivative thereof,
(b) optionally, at least one acid comprising only one reactive carboxylic acid group [acid (MA)], and
(c) adipic acid in an amount from 0 to 8 % moles, based on all the components of the acid component (AA),

- an amine [amine component (N)], comprising at least one diamine, and, optionally, at least one amine comprising only one reactive amine group [agent (MN)] ;
wherein in said polyamide (A) the number of amino end groups is equal to or in excess to the number of carboxyl end groups and wherein the number of amino end groups is equal to or less than 200 $\mu$eq/g and the number of carboxyl end groups is equal to or less than 100 $\mu$eq/g ;

(ii) at least one pigment selected from the group consisting of titanium dioxide ($TiO_2$), zinc disulfide ($ZnS_2$), zinc oxide (ZnO) and barium sulphate ($BaSO_4$) [pigment (P)] ; and
(iii) optionally, at least one reinforcing filler [filler (F)], different from pigment (P).

Fig. 1

**Fig. 2**

**Description**

**Field of invention**

The invention relates to an aromatic polyamide compositions comprising at least one polyamide having recurring units derived from at least one diamine and at least one dicarboxylic acid ; optionally, having reinforcing filler and a white pigment. In said polyamide in the composition, the number of amino end groups exceeds the number of carboxyl end groups. The invention further relates to the use of said composition for manufacturing shaped articles, and to shaped articles therefrom, including components of light emitting apparatuses, e.g. LED assemblies.

**Background of the invention**

Light emitting diode (LED) components, such as housings, reflectors, reflector cups, heatsink slugs, require an especially demanding combination of excellent colour and improved physical properties, so as to ensure good opacity and outstanding reflective properties both after high temperature processing and soldering conditions (during LED assembly manufacture) and after prolonged exposure to heat and radiation, such as those of continuous LED operations. This is particularly true for LED assemblies of new generations, adapted to higher conductive power dissipations, necessitating, notably, the use of a central heat-conducting slug in packages. While ceramics might be used for manufacturing above mentioned components, their inherent cost and highly demanding processing technologies have called for alternative materials. Therefore, plastics have been extensively studied and developed to this aim.

Various useful polymer compositions for LED applications are known, these ones usually include polycondensation polymers, such as polyphthalamides. One problem noted with the prior art compositions used in LED applications is that they tend to yellow when exposed to light and heat.

The resin compounds comprising appropriate reinforcing and pigment ingredients, generally titanium dioxide, are thus attracting great attention as useful raw materials for such LED components, exhibiting superior properties for moulding, providing moulded parts having thermal stability, including dimensional stability and retention of mechanical properties, during fabrication and end use, and suitably retaining whiteness and reflectivity during processing and end use.

Compounds of high melting polyamides containing terephthalic acid show utility as materials for the reflector plates/reflecting surfaces of lighting devices based upon LEDs.

EP 1591461 B1 discloses polyamide molding compositions based on 10T/6T copolyamides which can be used in reflectors. Table 1 is this patent discloses polyamide polymers having carboxyl end groups in excess to amino end groups.

The utility of LED lighting devices of increasing power and brightness in electronics, in signage, in automobiles and in residential and commercial lighting has driven manufacturing and end use criteria to include even higher initial and retained brightness and luminosity.

There is thus still a high need for polymer compositions which possess improved performances, including, notably, higher reflectance of light (in general, of visible light), higher whiteness, both initial and after thermal aging, while maintaining good processability (e.g. good moldability), high dimensional stability (notably low coefficient of linear expansion), high mechanical strength, high heat deflection temperature and high heat resistance (low discoloration and low loss of reflectance when exposed to a high temperature e.g. by means of soldering and the like). Said compositions can then suitable to be used for manufacturing LED components which have improved properties such as higher initial and retained brightness and luminosity.

**Summary of invention**

The Applicant has now found surprisingly that certain aromatic polyamide compositions based on certain polyamides comprising recurring units derived from at least one dicarboxylic acid and at least one diamine and having a well-defined total number of carboxyl and amino end groups and comprising specific ingredients are particularly effective in fulfilling above mentioned requirements.

The invention thus pertains to an aromatic polyamide composition [composition (C)] comprising :

   (i) an aromatic polyamide polymer [polyamide (A)] comprising recurring units derived from

   -    a carboxylic acid [acid component (AA)], comprising :

         (a) at least one dicarboxylic acid or derivative thereof,
         (b) optionally, at least one acid comprising only one reactive carboxylic acid group [acid (MA)], and
         (c) adipic acid in an amount from 0 to 8 % moles, based on all the components of the acid component (AA),

- an amine [amine component (N)], comprising at least one diamine, and, optionally, at least one amine comprising only one reactive amine group [agent (MN)] ;
wherein in said polyamide (A) the number of amino end groups is equal to or in excess to the number of carboxyl end groups and wherein the number of amino end groups is equal to or less than 200 $\mu$eq/g and the number of carboxyl end groups is equal to or less than 100 $\mu$eq/g ;

(ii) at least one pigment selected from the group consisting of titanium dioxide ($TiO_2$), zinc disulfide ($ZnS_2$), zinc oxide (ZnO) and barium sulphate ($BaSO_4$) [pigment (P)] ; and
(iii) optionally, at least one reinforcing filler [filler (F)], different from pigment (P).

The Applicant has surprisingly found that the composition (C), thanks to the combination of the particular polyamide(s) (A), possessing amino end groups in excess to carboxyl end groups and that in a particular amount, with above detailed ingredients, possesses outstanding light reflectance capabilities, both initial and, more importantly, after thermal aging, while maintaining good processability (e.g. good moldability), including the possibility of being processed in relatively smooth conditions (moderated temperatures), as well as all other desirable properties typical of polyamide compositions.

**Brief description of drawings**

Figure 1 is a top view LED comprising one or more component made from the composition of the invention.
Figure 2 is a power LED comprising one or more component made from the composition of the invention.

**Description of embodiments**

The expression 'derivative thereof when used in combination with the expression 'carboxylic acid' is intended to denote whichever derivative which is susceptible of reacting in polycondensation conditions to yield an amide bond. Examples of amide-forming derivatives include a mono- or di-alkyl ester, such as a mono- or di-methyl, ethyl or propyl ester, of such carboxylic acid ; a mono-or di-aryl ester thereof ; a mono- or di-acid halide thereof ; and a mono-or di-acid amide thereof, a mono- or di-carboxylate salt.
Advantageously, the ratio of the overall number of the amine groups in the amine component (N) in the polyamide (A) to the overall number of the acid groups in the acid component (AA) is from 1.20:1 to 1:1, preferably from 1.15:1 to 1:1, preferably from 1.10:1 to 1:1, preferably from 1.08:1 to 1:1, more preferably from 1.07:1 to 1:1.
For the purpose of the present invention, the expression "aromatic polyamide polymer" is intended to denote a polyamide that comprises more than 35 mol % of aromatic recurring units, preferably more than 45 mol %, more preferably more than 55 mol %, still more preferably more than 65 mol % and most preferably more than 75 mol %.
For the purpose of the present invention, the expression "aromatic recurring unit" is intended to denote any recurring unit that comprises at least one aromatic group. The aromatic recurring units may be formed by the polycondensation of at least one aromatic dicarboxylic acid with a diamine or by the polycondensation of at least one dicarboxylic acid with an aromatic diamine.
Said dicarboxylic acid can be an aromatic dicarboxylic acid [acid (AR)] or an aliphatic dicarboxylic acid [acid (AL)] different from adipic acid.
For the purpose of the present invention, a dicarboxylic acid is considered as "aromatic" when it comprises one or more than one aromatic group.
Non limitative examples of acids (AR) are notably phthalic acids [acids (PA)], including isophthalic acid (IA), terephthalic acid (TA) and orthophthalic acid (OA), 2,5-pyridinedicarboxylic acid, 2,4-pyridinedicarboxylic acid, 3,5-pyridinedicarboxylic acid, 2,2-bis(4-carboxyphenyl)propane, bis(4-carboxyphenyl)methane, 2,2-bis(4-carboxyphenyl)hexafluoropropane, 2,2-bis(4-carboxyphenyl)ketone, 4,4'-bis(4-carboxyphenyl)sulfone, 2,2-bis(3-carboxyphenyl)propane, bis(3-carboxyphenyl)methane, 2,2-bis(3-carboxyphenyl)hexafluoropropane, 2,2-bis(3-carboxyphenyl)ketone, bis(3-carboxyphenoxy)benzene, the 2,6-naphthalene dicarboxylic acid, 2,7-naphthalene dicarboxylic acid, 1,4-naphthalene dicarboxylic acid, 2,3-naphthalene dicarboxylic acid, 1,8-naphthalene dicarboxylic acid, 1,2-naphthalene dicarboxylic acid.
Among acids (AL) different from adipic acid, mention can be notably made of oxalic acid (HOOC-COOH), malonic acid ($HOOC-CH_2-COOH$), succinic acid [$HOOC-(CH_2)_2-COOH$], glutaric acid [$HOOC-(CH_2)_3-COOH$], 2,2-dime-thyl-glutaric acid [$HOOC-C(CH_3)_2-(CH_2)_2-COOH$], 2,4,4-trimethyl-adipic acid [$HOOC-CH(CH_3)-CH_2-C(CH_3)_2-CH_2-COOH$], pimelic acid [$HOOC-(CH_2)_5-COOH$], suberic acid [$HOOC-(CH_2)_6-COOH$], azelaic acid [$HOOC-(CH_2)_7-COOH$], sebacic acid [$HOOC-(CH_2)_8-COOH$], undecanedioic acid [$HOOC-(CH_2)_9-COOH$], dodecandioic acid [$HOOC-(CH_2)_{10}-COOH$], tetradecandioic acid [$HOOC-(CH_2)_{11}-COOH$], cis- and/or trans-cyclohexane-1,4-dicarboxylic acid and/or cis- and/or trans-cyclohexane-1,3-dicarboxylic acid (CHDA).

In one preferred embodiment of the present invention, the aromatic polyamide polymer [polyamide (A)] comprises recurring units derived from

- a carboxylic acid [acid component (AA)], comprising :

    (a) at least one phthalic acid [acid (PA)], and optionally,
    (b) at least one acid comprising only one reactive carboxylic acid group [acid (MA)], and
    (c) adipic acid in an amount from 0 to 8 % moles, based on all the components of the acid component (AA),

- an amine [amine component (N)], comprising at least one diamine, and, optionally, at least one amine comprising only one reactive amine group [agent (MN)] ;

wherein in said polyamide (A), the number of amino end groups is equal to or in excess to the number of carboxyl end groups and wherein the number of amino end groups is equal to or less than 200 µeq/g and the number of carboxyl end groups is equal to or less than 100 µeq/g.

The acid component (AA) comprises said at least one acid (PA) in an amount between 35 and 100 % moles, based on the all components of the acid component (AA).

The acid component (AA) comprises said at least one acid (PA) in an amount of at least 35, preferably of at least 50, more preferably of at least 65 % moles, based on all components of the acid component (AA).

The acid component (AA) comprises said at least one acid (PA) in an amount of at most 100, preferably of at most 85, more preferably of at most 80 % moles, based on all components of the acid component (AA).

According to this preferred embodiments of the present invention, the acid (PA) is selected from the group consisting of isophthalic acid (IA), terephthalic acid (TA) and orthophthalic acid (OA). One or more than one of said phthalic acid can be used. The acid (PA) is preferably terephthalic acid (TA), optionally in combination with isophthalic acid (IA).

The acid component (AA) comprises said at least one acid (TA) in an amount of at least 35, preferably of at least 50, more preferably of at least 65 % moles, based on all components of the acid component (AA).

The acid component according to this preferred embodiment comprises said acid (IA) in an amount of less than 50 %, preferably less than 35 % moles, based on the all components of the acid component (AA).

The acid component (AA) generally further comprises at least one dicarboxylic acid or derivative thereof different from acid (PA).

Some of the acid (PA) may be replaced by up to 50 %, preferably up to 35 % and in particular up to 30 % moles of at least one acid selected from the group consisting of an acid (AR), as described above, different from acid (PA) and an acid (AL) different from adipic acid, as detailed above, based on the all components of the acid component (AA).

The Applicant has surprisingly found that when the polyamide (A) compounded in the composition (C) is substantially free from adipic acid that the composition (C) having outstanding whiteness and retaining this property, even after thermal treatment.

Thus, the acid component (AA) in the polyamide (A) in the composition (C) advantageously comprises adipic acid in an amount from 0 to 8 % moles, preferably from 0 to 5 % moles, more preferably from 0 to 2 % moles, based on all components of the acid component (AA). Excellent results were obtained when the the acid component (AA) in the polyamide (A) in the composition (C) is free of adipic acid.

In a preferred embodiment of the present invention, the diamine component [amine component (N)] comprises at least one aliphatic alkylene-diamine [amine (AL)].

Said aliphatic alkylene-diamine are typically aliphatic alkylene diamines having 2 to18 carbon atoms.

Said amine (AL) is advantageously selected from the group consisting of 1,2-diaminoethane, 1,2-diaminopropane, propylene-1,3-diamine, 1,3-diaminobutane, 1,4-diaminobutane, 1,5-diaminopentane, 1,4-diamino-1,1-dimethylbutane, 1,4-diamino-1-ethylbutane, 1,4-diamino-1,2-dimethylbutane, 1,4-diamino-1,3-dimethylbutane, 1,4-diamino-1,4-dimethylbutane, 1,4-diamino-2,3-dimethylbutane, 1,2-diamino-1-butylethane, 1,6-diaminohexane, 1,7-diaminoheptane, 1,8-diamino-octane, 1,6-diamino-2,5-dimethylhexane, 1,6-diamino-2,4-dimethylhexane, 1,6-diamino-3,3-dimethylhexane, 1,6-diamino-2,2-dimethylhexane, 1,9-diaminononane, 1,6-diamino-2,2,4-trimethylhexane, 1,6-diamino-2,4,4-trimethylhexane, 1,7-diamino-2,3-dimethylheptane, 1,7-diamino-2,4-dimethylheptane, 1,7-diamino-2,5-dimethylheptane, 1,7-diamino-2,2-dimethylheptane, 1,10-diaminodecane, 1.8-diamino-1,3-dimethyloctane, 1,8-diamino-1,4-dimethyloctane, 1.8-diamino-2,4-dimethyloctane, 1.8-diamino-3,4-dimethyloctane, 1.8-diamino-4,5-dimethyloctane, 1.8-diamino-2,2-dimethyloctane, 1.8-diamino-3,3-dimethyloctane, 1,8-diamino-4,4-dimethyloctane, 1,6-diamino-2,4-diethylhexane, 1,9-diamino-5-methylnonane, 1,11-diaminoundecane and 1,12-diaminododecane.

The amine component (N) preferably comprises at least one diamine selected from the group consisting of 1,6-diaminohexane, 1,8-diamino-octane, 1,10-diaminodecane, 1,12-diaminododecane and mixtures thereof. More preferably, the amine component (N) comprises at least one diamine selected from the group consisting of 1,6-diaminohexane, 1,10-diaminodecane and mixtures thereof.

In addition to the at least one amine (AL), the amine component (N) can further comprise at least one diamine different from said amine (AL).

Said additional diamine can be notably an aromatic diamine [amine (AR)] or a cycloaliphatic diamine [amine (CAL)].

Non limitative examples of amine (AR) are notably selected from the group consisting of meta-phenylene diamine, meta-xylylene diamine, para-xylylene diamine and 4-(aminobenzyl)cyclohexylamine.

Non limitative examples of amine (CAL) are notably selected from the group consisting of 1,3-diaminocyclohexane, 1,4-diaminocyclohexane, 1,3-bis(aminomethyl)cyclohexane, 1,4-bis(aminomethyl)cyclohexane, bis(3-methyl-4-aminocyclohexyl)-methane, 4,4'-methylene-bis-cyclohexylamine, isophoronediamine.

In addition to the acid component (AA) and the amine component (N), as detailed above, the polyamide (A) of the present invention can further comprise at least one lactam or ω-amino acid.

Non limitative examples of lactam are notably selected from the group consisting of caprolactam and lauryl lactam.

Non limitative examples of ω-amino acid are notably selected from the group consisting of 6-aminohexanoic acid, 1-aza-2-cyclononanone, 1-aza-2-cyclododecanone, 11-aminoundecanoic acid, 12-aminododecanoic acid, 4-(aminomethyl)benzoic acid, cis-4- (aminomethyl)cyclohexanecarboxylic acid, trans-4- (aminomethyl)cyclohexanecarboxylic acid, cis-4-aminocyclohexanecarboxylic acid and trans-4-aminocyclohexanecarboxylic acid.

The polyamide (A) comprises said at least one lactam or ω-amino acid in an amount of at most 35 %, preferably of at most 25 %, more preferably of at most 20 % moles, based on the total of all components of the acid component (AA) and the amine component (N).

According to the present invention, the number of amino end groups is advantageously in excess to the number of carboxyl end groups in an amount of at least 1 μeq/g, at least 2 μeq/g, at least 3 μeq/g, at least 4 μeq/g, at least 5 μeq/g, at least 6 μeq/g, at least 7 μeq/g, at least 8 μeq/g, at least 9 μeq/g, at least 10 μeq/g, at least 11 μeq/g, at least 12 μeq/g, at least 13 μeq/g, at least 14 μeq/g, at least 15 μeq/g, at least 16 μeq/g, at least 17 μeq/g, at least 18 μeq/g, at least 19 μeq/g, at least 20 μeq/g, at least 21 μeq/g, at least 22 μeq/g, at least 23 μeq/g, at least 24 μeq/g, at least 25 μeq/g, at least 26 μeq/g, at least 27 μeq/g, at least 28 μeq/g, at least 29 μeq/g, at least 30 μeq/g, at least 31 μeq/g, at least 32 μeq/g, at least 33 μeq/g, at least 34 μeq/g, at least 35 μeq/g.

According to the present invention, the number of amino end groups is advantageously in excess to the number of carboxyl end groups in an amount between 1 and 200 μeq/g, preferably in an amount between 5 and 170 μeq/g, more preferably in an amount between 15 and 150 μeq/g, even more preferably in an amount between 30 and 100 μeq/g, most preferably in an amount between 35 and 60 μeq/g.

According to the present invention, the number of amino end groups is advantageously in excess to the number of carboxyl end groups in an amount of at most 200 μeq/g, at most than 195 μeq/g, at most than 190 μeq/g, at most than 185 μeq/g, at most than 180 μeq/g, at most than 175 μeq/g, at most than 170 μeq/g, at most than 165 μeq/g, at most than 160 μeq/g, at most than 155 μeq/g, at most than 150 μeq/g, at most than 145 μeq/g, at most than 140 μeq/g, at most than 135 μeq/g, at most than 130 μeq/g, at most than 125 μeq/g, at most than 120 μeq/g, at most than 115 μeq/g, at most than 110 μeq/g, at most than 105 μeq/g, at most than 100 μeq/g, at most than 95 μeq/g, at most than 90 μeq/g, at most than 85 μeq/g, at most than 80 μeq/g, at most than 75 μeq/g, at most than 70 μeq/g, at most than 65 μeq/g, at most than 60 μeq/g.

The Applicant has surprisingly found that when the polyamide (A) having amino end groups in excess to carboxyl end groups and that in a particular amount, as indicated above, this feature is particularly advantageous, as mentioned above, for providing a composition (C) having outstanding whiteness and retaining this property, even after thermal treatment.

According to the present invention, the polyamide (A) has advantageously the number of amino end groups being equal to or less than 200 μeq/g, less than 195 μeq/g, less than 190 μeq/g, less than 185 μeq/g, less than 180 μeq/g, less than 175 μeq/g, less than 170 μeq/g, less than 165 μeq/g, less than 160 μeq/g, less than 155 μeq/g, less than 150 μeq/g, less than 145 μeq/g, less than 140 μeq/g, less than 135 μeq/g, less than 130 μeq/g, less than 125 μeq/g, less than 120 μeq/g, less than 115 μeq/g, less than 110 μeq/g, less than 105 μeq/g, less than 100 μeq/g, less than 95 μeq/g, less than 90 μeq/g, less than 85 μeq/g, less than 80 μeq/g, less than 75 μeq/g, less than 70 μeq/g, less than 65 μeq/g, less than 60 μeq/g.

According to the present invention, the polyamide (A) has advantageously the number of carboxyl end groups being equal to or less than 100 μeq/g, less than 95 μeq/g, less than 90 μeq/g, less than 85 μeq/g, less than 80 μeq/g, less than 75 μeq/g, less than 70 μeq/g, less than 65 μeq/g, less than 60 μeq/g, less than 55 μeq/g, less than 50 μeq/g, less than 45 μeq/g, less than 40 μeq/g, less than 35 μeq/g, less than 30 μeq/g, less than 25 μeq/g, less than 20 μeq/g, less than 15 μeq/g, less than 10 μeq/g, less than 5 μeq/g.

According to the present invention, the polyamide (A) has advantageously 10 - 200 μeq/g of amino end groups,

preferably 15 - 170 μeq/g of amino end groups, more preferably 20 - 150 μeq/g of amino end groups, even more preferably 25 - 120 μeq/g of amino end groups, most preferably 30 - 105 μeq/g of amino end groups.

According to the present invention, the polyamide (A) has advantageously 0 - 100 μeq/g of carboxyl end groups, preferably 5 - 95 μeq/g of carboxyl end groups, more preferably 10 - 90 μeq/g of carboxyl end groups, most preferably 13 - 85 μeq/g of carboxyl end groups.

The Applicant has surprisingly found that when the polyamide (A) compounded in the composition (C) possesses further a particular total number of carboxyl and amino end groups, this feature is also particularly advantageous for providing a composition (C) having outstanding whiteness and retaining this property, even after thermal treatment.

In a specific embodiment, the polyamide (A) in the composition (C) of the present invention has advantageously a total number of carboxyl and amino end groups equal to or less than 200 μeq/g, less than 195 μeq/g, less than 190 μeq/g, less than 185 μeq/g, less than 180 μeq/g, less than 175 μeq/g, less than 170 μeq/g, less than 165 μeq/g, less than 160 μeq/g, less than 155 μeq/g, less than 150 μeq/g, less than 145 μeq/g, less than 140 μeq/g, less than 135 μeq/g, less than 130 μeq/g, less than 125 μeq/g, less than 120 μeq/g, less than 115 μeq/g, less than 110 μeq/g, less than 105 μeq/g, less than 100 μeq/g, less than 95 μeq/g, less than 90 μeq/g, less than 85 μeq/g, less than 80 μeq/g, less than 75 μeq/g, less than 70 μeq/g, less than 65 μeq/g, less than 60 μeq/g.

According to the present invention, the polyamide (A) has advantageously a total number of carboxyl and amino end groups between 10 and 200 μeq/g, preferably between 15 and 195 μeq/g, more preferably between 20 and 190 μeq/g, most preferably between 25 and 180 μeq/g.

The total number of carboxyl and amino end groups in the polyamide (A) of the present invention are suitably determined by a titration method, preferably a potentiometric titration method.

The polyamide (A) is generally dissolved in a solvent suitable for titration. Non limitative examples of solvents and solvent blends suitable to use in the titration of polyamides (A) of the present invention for the determination of the total number of carboxyl end groups are for example o-cresol and o-cresol/chloroform. Formaldehyde is generally added to react with amine end groups so as to suitably suppress salt formation between carboxyl and amine end groups.

Non limitative examples of solvents and solvent blends suitable to use in the titration of polyamides (A) of the present invention for the determination of the total number of amino end groups are for example phenol/methanol, phenol/ethanol, and hexafluoroisopropanol.

For the determination of the total number of carboxyl end groups, a base is suitably used as titrant. Suitable bases are in general those having a $K_b$ value equal to of at least 1000 times greater than the $K_b$ value of the de-protonated carboxyl end group. Non limitative examples of suitable bases are notably alkali metal hydroxides such as sodium hydroxide, potassium hydroxide, lithium hydroxide, cesium hydroxide, alkaline earth metal hydroxides such as calcium hydroxide, barium hydroxide, magnesium hydroxide, strontium hydroxide, and basic alkali metal salts such as sodium carbonate, sodium hydrogencarbonate, potassium carbonate and potassium hydrogencarbonate. Preferred bases are sodium hydroxide and potassium hydroxide. Most preferred base is potassium hydroxide.

The base is in general present in the form of an aqueous solution or a solution of the base in an organic solvent. The organic solvent to be used may, for example, be dimethyl formamide, dimethyl acetamide, dimethylsulfoxide, sulfolane, tetrahydrofuran, acetonitrile, dioxane, methanol, ethanol. Particularly preferred among them, is methanol.

For the purpose of the present invention, the term "aqueous solution" refers to solutions of water soluble compounds in water, for example salt water or any other aqueous mineral salt solution.

For the amino end groups, an acid is suitably used as titrant. Suitable acids are in general those having a $K_a$ value equal to or at least 1000 times greater than the $K_a$ value of the protonated amine end group. Non limitative examples of acids are notably hydrochloric acid.

In addition, some other analytical methods can be used for the determination of the total number of carboxyl and amino end groups in said polyamide (A), including notably spectroscopic measurements such as IR and NMR or radioactive measurements such as for polymers with labeled endgroups.

If desired, the polyamide (A) of the present invention may also be endcapped by any end-capping agent [agent (M)]. Said agent (M) is in general selected from the group consisting of an acid comprising only one reactive carboxylic acid group [acid (MA)] and an amine comprising only one reactive amine group [agent (MN)].

The expression 'acid comprising only one reactive carboxylic acid group' and acid (MA) is intended to encompass not only mono-carboxylic acids but also acids comprising more than one carboxylic acid group or derivative thereof, but wherein only one of said carboxylic acid group has reactivity in polycondensation reaction with the amine component (N).

It is nevertheless generally preferred that said acid (MA) comprises only one carboxylic acid group.

Thus, acid (MA) is preferably selected from the group consisting of acetic acid, propionic acid, butyric acid, valeric acid, caproic acid, caprylic acid, lauric acid, stearic acid, cyclohexanecarboxylic acid, benzoic acid, preferably from acetic acid and benzoic acid.

Similarly, the expression 'amine comprising only one reactive amine group' and amine (MN) is intended to encompass not only mono-amine but also amines comprising more than one amine group or derivative thereof, but wherein only one of said amine group has reactivity in polycondensation reaction with the acid component (AA).

It is nevertheless generally preferred that said amine (MN) comprises only one amine group.

Thus, amine (MN) is preferably selected from the group consisting of methylamine, ethylamine, butylamine, octylamine, aniline, toluidine

As said, the overall amount of agent (M) in polyamide (A), computed as

$$\text{agent (M) (\%moles)} = \left[ \frac{\text{moles of agent (MA)}}{\text{total moles of acid component (AA)}} + \frac{\text{moles of agent (MN)}}{\text{total moles of amine component (N)}} \right] \cdot 100$$

is comprised between 2 and 8 % moles, being understood that the agent (M) might advantageously be agent (MA) alone, agent (MN) alone or a combination thereof. In other words, in above mentioned formula, the amount of agent (MA) with respect to the total moles of acid component (AA) can be from 0 to 8 % moles, the amount of agent (MN) with respect to the total moles of amine component (N) can be from 0 to 8 % moles, with the additional provisions that at least one of these amounts is not null, and their sum is of 2 to 8 % moles.

The amount of agent (M), as above described, is of at most 8 % moles, preferably at most 7 % moles, more preferably at most 6 % moles, more preferably at most 4 % moles.

The amount of agent (M), as above described, is of at least 2 % moles, preferably at least 3 % moles.

Non limitative examples of polyamides (A) according to the present invention are : the polymer of terephthalic acid with 1,9-nonamethylenediamine, the polymer of terephthalic acid with 1,10-decamethylenediamine, the polymer of terephthalic acid with dodecamethylenediamine, the polymer of 1,11-undecanediamine with terephthalic acid, the copolymer of terephthalic acid and isophthalic acid with hexamethylenediamine, the copolymer of terephthalic acid with hexamethylenediamine and decamethylenediamine ; the copolymer of terephthalic acid and isophthalic acid with hexamethylenediamine and decamethylenediamine ; the copolymer of terephthalic acid with decamethylenediamine and 11-amino-undecanoic acid, the copolymer of terephthalic acid with hexamethylenediamine and 11-amino-undecanoic acid ; the copolymer of terephthalic acid with hexamethylenediamine and bis-1,4-aminomethylcyclohexane ; the copolymer of terephthalic acid with hexamethylenediamine and bis-1,3-aminomethylcyclohexane ; the copolymer of hexamethylenediamine with terephthalic acid and 2,6-napthalenedicarboxylic acid ; the copolymer of hexamethylenediamine with terephthalic acid and sebacic acid ; the copolymer of hexamethylenediamine with terephthalic acid and 1,12 diaminododecanoic acid ; the copolymer of hexamethylenediamine with terephthalic acid, isophthalic acid and 1,4-cyclohexanedicarboxylic acid ; the copolymer of decamethylenediamine with terephthalic acid and 4-aminocyclohexanecarboxylic acid ; the copolymer of decamethylenediamine with terephthalic acid and 4-(aminomethyl)-cyclohexanecarboxylic acid ; the polymer of decamethylenediamine with 2,6-napthalenedicarboxylic acid ; the copolymer of 2,6-napthalenedicarboxylic acid with hexamethylenediamine and decamethylenediamine ; the copolymer of 2,6-napthalenedicarboxylic acid with hexamethylenediamine and decamethylenediamine ; the polymer of decamethylenediamine with 1,4-cyclohexanedicarboxylic acid, the copolymer of hexamethylenediamine with 11-amino-undecanoic acid and 2,6-napthalenedicarboxylic acid ; the copolymer of terephthalic acid with hexamethylenediamine and 2-methylpentamethylenediamine ; the copolymer of terephthalic acid with decamethylenediamine and 2-methylpentamethylenediamine ; the copolymer of 2,6-napthalenedicarboxylic with hexamethylenediamine and 2-methylpentamethylenediamine ; the copolymer of 1,4-cyclohexanedicarboxylic acid with decamethylenediamine and 2-methylpentamethylenediamine.

A first group of preferred polyamides (A) are those consisting essentially of recurring units formed by the polycondensation reaction between terephthalic acid, benzoic acid and 1,6-diaminohexane, and, optionally isophthalic acid.

In such a case, terephthalic acid is advantageously present in about 55-85 mol. %, preferably in about 60-80 mol. % and most preferably in about 65 mol. %, isophthalic acid is advantageously present in about 0-40 mol. %, preferably in about 15-35 mol. % and most preferably in about 15-35 mol. %.

A second group of preferred polyamides (A) are those consisting essentially of recurring units formed by the polycondensation reaction between terephthalic acid, isophthalic acid, 1,10-diaminodecane and 1,6-diaminohexane.

A third group of preferred polyamides (A) are those consisting essentially of recurring units formed by the polycondensation reaction between terephthalic acid, isophthalic acid and 1,10-diaminodecane.

The composition (C) may comprise one or more than one polyamide (A) as above detailed.

The weight percent of the polyamide (A) in the composition (C) is generally of at least 30 wt. %, preferably of at least 40 wt. %, and more preferably of at least 50 wt. %, based on the total weight of the composition (C). It is further understood that the weight percent of the polyamide (A) in the composition (C) will generally be of at most 90 wt. %, preferably of at most 80 wt. % and most preferably of at most 60 wt. %, based on the total weight of the composition (C).

Excellent results were obtained when the composition (C) comprised the polyamide (A) in an amount of 40-70 wt. %, preferably of 50-60 wt. %, based on the total weight of the composition (C).

Reinforcing fillers [fillers (F)] which are suitable to be used in the composition (C) of the invention are well known by the skilled in the art.

Having regards to its morphology, the filler (F) of the composition (C) is generally selected from the group consisting of fibrous fillers and particulate fillers. Typically, the filler (F) is selected from the group consisting of mineral fillers (such as talc, mica, kaolin, calcium carbonate, calcium silicate, magnesium carbonate), glass fiber, carbon fibers, synthetic polymeric fiber, aramid fiber, aluminum fiber, titanium fiber, magnesium fiber, boron carbide fibers, rock wool fiber, steel fiber, wollastonite, inorganic whiskers. Still more preferably, it is selected from mica, kaolin, calcium silicate, magnesium carbonate, inorganic whiskers, glass fiber and wollastonite.

A particular class of fibrous fillers which are advantageously usable in the composition (C) consists of whiskers, i.e. single crystal fibers made from various raw materials, such as $Al_2O_3$, SiC, BC, Fe and Ni.

According to certain preferred embodiments, the filler (F) is selected from the group consisting of fibrous fillers. Among fibrous fillers, glass fibers are preferred ; non limitative examples of glass fibers include notably chopped strand A-, E-, C-, D-, S- and R-glass fibers, as described in chapter 5.2.3, p. 43-48 of Additives for Plastics Handbook, 2nd edition, John Murphy, the whole content of which is herein incorporated by reference. Glass fibers fillers useful in composition (C) may have a round cross-section or a non-circular cross-section.

In a preferred embodiment of the present invention, the filler (F) is selected from the group consisting of wollastonite fillers and glass fiber fillers. Excellent results were obtained when wollastonite and/or glass fibers were used.

The weight percent of the filler (F) in the composition (C) is generally of at least 5 wt. %, preferably of at least 10 wt. %, more preferably of at least 15 wt. % and most preferably of at least 20 wt. %, based on the total weight of composition (C). The weight percent of the filler (F) is generally of at most 50 wt. %, preferably of at most 40 wt. % and most preferably of at most 30 wt. %, based on the total weight of the composition (C).

Excellent results were obtained when the filler (F) was used in an amount of 10-40 wt. %, preferably of 20-30 wt. %, based on the total weight of the composition (C).

Above mentioned fillers are typically known as white pigments, in that they absorb limited incident visible radiation and scatter most of said incident visible radiation. Otherwise stated, the pigments (P) used in the composition (C) generally absorb essentially no light in the visible region (wavelength 400 - 800 nm), but disperse incident radiation in this region as completely as possible.

The pigment (P) is selected from the group consisting of titanium dioxide ($TiO_2$), zinc disulfide ($ZnS_2$), zinc oxide (ZnO) and barium sulphate ($BaSO_4$).

The pigment (P) is advantageously present in the composition (C) under the form of particles having an average particle size (APS) of generally less than 250 $\mu$m, preferably less than 100 $\mu$m, more preferably of less than 5 $\mu$m. Larger sizes may deleteriously affect the properties of the composition.

While pigments (P) having larger APS can be used, these pigments (P) are less advantageous, in that they might impair other relevant properties (e.g. mechanical properties) of the composition (C).

Preferably, the APS of the pigment (P) is of below 1 $\mu$m. While lower boundaries for APS of pigment (P) is not particularly critical, it is generally understood that pigment (P) will have an APS of at least 0.1 $\mu$m.

The shape of the particles is not particularly limited ; they may be notably round, flaky, flat and so on.

The pigment (P) is preferably titanium dioxide.

The nature of the titanium dioxide pigment is not particularly limited, and a variety of crystalline forms such as the anatase form, the rutile form and the monoclinic type can be advantageously used. However, the rutile form is generally preferred due its higher refraction index and its superior light stability. Titanium dioxide pigment may be treated on its surface with at least one treatment agent, even if embodiments wherein titanium dioxide pigments have no surface treatment are also suitable. Preferably the APS of the titanium oxide pigment is in the range of 0.15 $\mu$m to 0.35 $\mu$m.

The weight percent of the pigment (P) in the composition (C) is generally of at least 1 wt. %, preferably of at least 6 wt. %, more preferably of at least 8 wt. % and most preferably of at least 15 wt. %, based on the total weight of the composition (C). Besides, the weight percent of the pigment (P) is generally of at most 50 wt. %, preferably of at most 40 wt. %, more preferably of at most 30 wt. % and most preferably of at most 30 wt. %, based on the total weight of the composition (C).

Excellent results were obtained when the pigment (P) was used in an amount of 10-30 wt. %, preferably of 15-25 wt. %, based on the total weight of the composition (C).

*Optional ingredients*

The composition (C) can optionally comprise additional components such as stabilizing additive, notably mould release agents, plasticizers, lubricants, thermal stabilizers, light stabilizers and antioxidants etc.

The composition (C) advantageously further comprises at least a stabilizing additive. The stabilizing additive may be present in an amount of 1 to 10 wt. %, based on the total weight of the composition (C).

The levels of these optional additives will be determined for the particular use envisioned, with generally up to 20 wt. %, preferably up to 10 wt. %, more preferably up to 5 wt. % and still more preferably up to 2 wt. % (based on the total weight of the polymer composition) of such additional additives considered to be within the range of ordinary practice in the extrusion art.

Certain stabilizers such as hindered amine light stabilizers (HALS) may be present in the composition. For example one or more of the group of hindered amines selected from the group bis(2,2,6,6- tetramethylpiperidin-4-yl) sebacate, bis(1,2,2,6,6-pentamethyl piperidin-4-yl)sebacate, di(1,2,2,6,6-pentamethylpiperidin-4-yl) (3,5-di-tert- butyl-4-hydroxybenzyl)butylmalonate, the polycondensation product of 1-(2-hydroxyethyl)-2,2,6,6-tetramethyl-4-hydroxypiperidine and succinic acid, the polycondensation product of 2,4-dichloro-6-tert-octylamino-s-triazine and 4,4'- hexamethylenebis(amino-2,2,6,6-tetramethylpiperidine), N,N',N'',N'''-tetrakis[(4,6-bis(butyl-(1,2,2,6,6-pentamethylpiperidin-4-y-1) amino)-s-triazine-2-yl]- 1, 10-diamino-4,7-diazadecane, di-(I-octyloxy-2,2,6,6-tetramethylpiperidin-4-yl)sebacate, di-(1-cyclohexyloxy-2,2,6,6-tetramethylpiperidin-4-yl)succinate, 1-octyloxy-2,2,6,6-tetramethyl-4-hydroxy-piperidine, poly-{[6-tert-octylamino-s-triazin-2,4-diyl][2-(1-cyclohexyloxy-2,2,6,6-tetramethylpiperidin-4-yl)imino-hexamethylene-[4-(1-cyclohexyloxy-2,2,6,6-tetramethylpiperidin-4-yl)imino], or 2,4,6-tris[N-(1-cyclohexyloxy-2,2,6,6-tetramethylpiperidin-4-yl)-n-butylamino]-s-triazine may be present in the composition according to the present invention.

The composition (C) can additionally contain one or more other UV absorbers selected from the group consisting of s-triazines, oxanilides, hydroxybenzophenones, benzoates and α-cyanoacrylates.

Thermal stabilizers may also be included in the composition (C). The thermal stabilizers commonly used in polyamide compositions are well known in the art. They can typically be one or more selected from, 3,9-bis[1,1-dimethyl-2-[(3-tert-butyl-4-hydroxy-5-methylphenyl)propionyloxy]ethyl]-2,4,8,10-tetraoxaspiro[5.5]undecane, pentaerythritol tetrakis(3-(3,5-di-tert-butyl-4-hydroxyphenyl)propionate), 3,3'-bis(3,5-di-tert-butyl-4-hydroxyphenyl)-N,N'-hexamethylenedipropionamide, 1,3,5-tris(3,5-di-(tert)-butyl-4-hydroxybenzyl)-1,3,5-triazine-2,4,6(1H,3H,5H)-trione, 1,3,5-triazine-2,4,6(1H,3H,SH)-trione,1,3,5-tris[[4-(1,1-dimethylethyl)-3-hydroxy-2,6-dimethylphenyl]methyl], benzenepropanoic acid, 3-(1,1-dimethylethyl)-b-[3-(1,1-dimethylethyl)-4-hydroxyphenyl]-4-hydroxy-b-methyl-, 1,1'-(1,2-ethanediyl)ester, bis (1,2,2,6,6-pentamethyl-4-piperidyl) [[3,5-bis(1,1-dimethylethyl)-4-hydroxyphenyl]methyl]butylmalonate, 2-(4,6-diphenyl-1,3,5-triazin-2-yl-)-5-((hexyl)oxyl-phenol, 2,4,8,10-tetraoxa-3,9-diphodphaspiro[5,5]undecane,3,9-bis[2,6-bis-1,1-dimethylethyl]-4-methylphenoxy], 12H dibenzo [d,g] [1,3,2]dioxaphosphocin,2,4,8,10-tetrakis(1,1-dimethylethyl)-6-[(2-ethylhexyl)oxy], 2,4,8,10-tetraoxa-3,9-diphosphaspiro[5.5]undecane,3,9-bis[2,4-bis(1-methyl-1-phenylethyl)phenoxy], tris(2,4-di-(tert)-butylphenyl)phosphate, bis-2,4-di-tert-butylphenyl)pentaerythritol diphosphite, 2,4,8,10-tetraoxa-3,9-diphosphaspiro[5.5]undecane,3,9-bis(octadecyloxy), 2,4,8,10-tetraoxa-3,9-diphosphaspiro[5.5]undecane,3,9-bis[2,4-bis (1-methyl-1-phenylethyl)phenoxy], 2-(tert-Butyl)-6-methyl-4-(3-((2,4,8,10-tetrakis(tert-butyl)dibenzo[d,f][1,3,2]dioxaphosphepin-6-yl)oxy)propyl)phenol and bis[4-(2-phenyl-2-propyl)phenyl] amine.

In a particular embodiment the composition does not contain any hindered amine light stabilizer, does not contain any thermal stabilizer, or does not contain any of a hindered amine light stabilizer and a thermal stabilizer.

### The article

An aspect of the present invention also provides an article comprising at least one component comprising the polyamide composition (C), as above detailed, which provides various advantages over prior art parts and articles, in particular an increased resistance to concurrent exposure to heat and radiation (both visible and UV) while maintaining all their other properties at a high level. Preferably, the article or part of the article consists of the composition (C) as above detailed.

In a particular embodiment, the article is a light emission apparatus.

Non limitative examples of light emission apparatuses are keyless entry systems of an automobile, lightings in a refrigerator, liquid crystal display apparatuses, automobile front panel lighting apparatuses, desk lamps, headlights, household electrical appliance indicators and outdoor display apparatuses such as traffic signs, and optoelectronic devices comprising at least one semi-conductor chip that emits and/or transmits electromagnetic radiation commonly known as Light Emitting Diodes devices (LEDs). Preferably, the light emission apparatus is a Light Emitting Diode device (LED).

LEDs are preferably chosen from the group of top view LEDs, side view LEDs and power LEDs. Top view and side view LEDs comprise usually a basic housing, which, in general, acts as reflector ; besides, top view and side view LEDs usually do not comprise any heatsink slug. On the other hand, power LEDs comprise usually a heatsink slug, which, in general, acts as reflector ; power LEDs usually further comprise a basic housing, which is a part distinct from the heatsink slug.

The top view LEDs are notably used in automotive lighting applications such as instrumental panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

The LED according to the present invention comprises at least one part comprising the composition (C) as above described. The part is preferably selected from the group consisting of basic housings and heatsink slugs. The part made from the composition (C), as above detailed, is generally intended to act as reflector.

Preferably at least 50 wt. % and more preferably more than 80 wt. % of the part comprises the composition (C), being understood that the part may possibly further contain other materials, e.g. a metal ; for example, for certain end uses, the surface of certain parts made from the composition (C), as above detailed, and acting as reflector, may be metal plated. More preferably, more than 90 wt. % of the part comprises the composition (C). Still more preferably, the part consists essentially of the composition (C). The most preferably, the part consists of the composition (C).

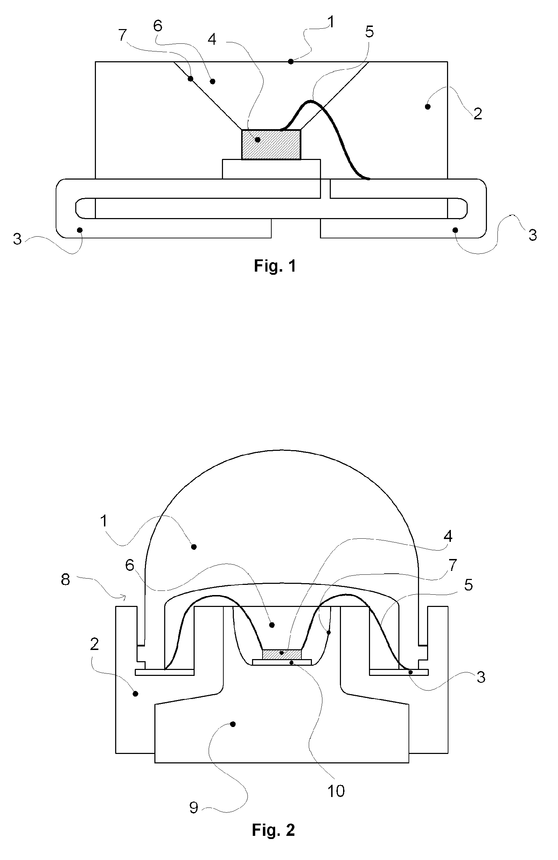

An exemplary embodiment of a top view LED is provided in Figure 1, which illustrates a sectional view of said embodiment. The top view LED 1 comprises a basic housing 2 comprising, and preferably consisting of, the composition (C) as above detailed. As will be detailed hereafter, the basic housing 2 acts also as reflector cup. No heatsink slug is present. Usually, the LED 1 further comprises a prefabricated electrical lead frame 3. Lead frame 3 can be advantageously encapsulated by injection moulding with the composition (C) included in the basic housing 2.

The basic housing 2 has a cavity 6. A semiconductor chip 4 that emits electromagnetic radiations, such as a LED chip, is mounted inside such cavity. The semiconductor chip 4 is generally bonded and electrically contact-connected on one of the lead frame terminals by means of a bonding wire 5.

A transparent or translucent potting compound (e.g. an epoxy, a polycarbonate or a silicone resin, not shown in Figure 1) is generally built into the cavity in order to protect the LED chip. It is customary, for the purpose of increasing the external efficiency of the LED chip, to shape the cavity of the basic housing with non perpendicular inner areas in such a way that the cavity acquires a form opening towards the front side (the sectional view of the inner wall of the cavity may have, for instance, the form of an oblique straight line, as in the exemplary embodiment in accordance with Figure 1, or that of a parabola).

Thus, the inner walls 7 of the cavity serve as reflector cup for the radiation which is emitted laterally by the semiconductor chip, notably reflecting this radiation towards the front side of the basic housing.

It is understood that the number of chips which can be mounted in the cavity of the basic housing, as well as the number of cavities which can be formed inside a basic housing, is not restricted to one.

An exemplary embodiment of a power LED is provided in Figure 2, which illustrates a sectional view of said embodiment. The power LED 8 comprises advantageously an aspherical lens 1 and a basic housing 2 comprising, and preferably consisting of, the composition (C), as above detailed. As in the previous embodiment, the LED 8 further comprises a prefabricated electrical lead frame 3.

The power LED 8 also comprises a carrier body or heatsink slug 9 which may comprise, or consist of, the composition (C) as above detailed. A cavity 6 is realized in the upper portion of the heatsink slug 9. A semiconductor LED chip 4 that emits electromagnetic radiations is mounted on the bottom area of cavity 6 and it is generally fixed by means of a chip carrier substrate or solder connection 10 to the heatsink slug 9. The solder connection 10 is generally an epoxy resin or another equivalent adhesive material. The LED chip is generally conductively connected to the electric terminals of the lead frame 3 via the bonding wires 5.

The inner walls 7 of the cavity 6 run generally from the bottom area of the cavity to the front side so as to form a reflector cup increasing the external efficiency of the LED chip. The inner walls 7 of the reflector cup may be, for example, straight and oblique or concavely curved (like in the exemplary embodiment in accordance with Figure 2).

The lead frame 3 and the heatsink slug 9 are generally encapsulated within the basic housing 2. In order to protect the LED chip 4, the cavity is generally completely filled, likewise in the first exemplary embodiment of Figure 1, with a radiation- transmissive, for example transparent, encapsulation compound (the encapsulant is not shown in Figure 2). The composition (C) as above detailed is particularly suitable for making basic housings and/or heatsink slugs as above described, because, besides having excellent thermal conductivity thus allowing the heat produced by the optoelectronic device to be easily dissipated, it has also good mechanical properties, high heat deflection temperature, good plateability, good adhesion to lead frame, excellent optical properties, notably excellent initial whiteness and high retention of reflectance, even after prolonged exposure to heat and radiation.

**EXAMPLES**

The disclosure will now be illustrated with working examples, which are intended to illustrate the working of disclosure and not intended to take restrictively to imply any limitations on the scope of the present disclosure.

The following commercially available materials were used :

*Wollastonite :* Vansil® HR-1500 available from RT Vanderbilt - 9 median particle size - 14:1 aspect ratio (as specified by supplier)

*Titanium Dioxide :* Tipaque PC-3 available from Ishihara Sangyo Kaisha, Ltd - rutile $TiO_2$ manufactured by chloride process, treated with silica and alumina.

Resins used in the examples and comparative examples were evaluated through potentiometric titration of amino and carboxyl end groups whereby the polymer samples were dissolved in appropriate solvents (see details below). Titrations were performed at room temperature using a Brinkmann Model 686, 670 or 726 Titroprocessor or equivalent. Temperature variations greater than +/- 2°C were noted. For the amine end group titrations, a Brinkmann combination pH electrode with sleeve junction 6.0219.100 or 6.0255.100 or equivalent was employed. For the carboxyl end group titrations, a dual electrode system (a Brinkmann pH electrode, 6.0101.100 or 6.0133.100 or equivalent and a Brinkmann grounded tip reference electrode, 6.1540.010 or equivalent) was used.

Calculations were corrected with titrant volumes determined for the appropriate solvent blank.

For the carboxyl end group titration, formaldehyde was added to react with the amine groups to suppress salt formation between the amines and carboxyls.

**Determination of the concentration of carboxyl end groups (CEG) :**

Resin, 0.3 g, was dissolved in 6 mL o-cresol at about 100°C. Chloroform, 6 mL, and 50 $\mu$L aqueous formaldehyde (37 wt %) were added. The concentration of carboxyl end groups, expressed in $\mu$eq/g polymer, was determined by potentiometric titration of this solution with 0.1 N KOH in methanol. Experimental data are summarized in Table 1.

**Determination of the concentration of amino end groups (AEG) :**

Resin, 0.4 g, was dissolved in 15 mL hexafluoroisopropanol at ambient temperature. Water, 0.1 mL, was added. The concentration of amino end groups, expresses in $\mu$eq/g polymer, was determined by potentiometric titration of this solution with 0.1 N HCL. Experimental data are summarized in Table 1.

**Preparation of the polyamide compositions PA 6T/6I with repeat unit mole ratio of hexamethylene terephthalamide and hexamethylene isophthalamide of 70:30, Example 1 (Ex-1):**

A stirred batch vessel was charged with a mixture comprising 31.5 wt % hexamethylenediamine, 28.4 wt % terephthalic acid, 12.2 wt % isophthalic acid, 0.83 % acetic acid, 0.082 wt % sodium hypophosphite and 27 wt % distilled water. A salt solution was obtained by heating the above described mixture at approximately 135°C. The contents were pumped continuously to a reactor zone maintained at about 185 psig and 220°C, then to a zone maintained at about 298°C and 1800 psig, then through a tubular reactor at 100 psig and heated with oil at 349°C and into a vented twin-screw extruder equipped with a rear, middle and forward vacuum vents and then to a pelletizer.

**Example 2 (Ex-2)** : The resin for Example 2 was obtained by solid state polymerization of EX-1 resin at 215°C in a Rotary Vacuum Drier.

**Preparation of the polyamide compositions PA 6T/6I with repeat unit mole ratio of hexamethylene terephthalamide and hexamethylene isophthalamide of 70:30, example 3 (Ex-3) :**

The procedure followed for Example 1 was modified by charging a mixture comprising 30.6 wt % hexamethylenediamine, 29.1 wt % terephthalic acid, 12.4 wt % isophthalic acid, 0.83 % acetic acid, 0.082 wt % sodium hypophosphite and 27 wt % distilled water.

**Example 4 (Ex-4)** : The resin for Example 4 was obtained by solid state polymerization of EX-3 resin at 215°C in a Rotary Vacuum Drier.

**Preparation of the polyamide compositions PA 6T/6I with repeat unit mole ratio of hexamethylene terephthalamide and hexamethylene isophthalamide of 70:30, comparative example 5 (Cex - 5) :**

The procedure followed for Example 1 was modified by charging a mixture comprising 30.1 wt % hexamethylenediamine, 29.4 wt % terephthalic acid, 12.6 wt % isophthalic acid, 0.83 % acetic acid, 0.082 wt % sodium hypophosphite and 27 wt % distilled water.

**Comparative Example 6 (Cex-6)** : The resin for Comparative Example 5 was obtained by solid state polymerization of CE-5 resin at 215 °C in a Rotary Vacuum Drier.

**Table 1 : Summary of the experimental data**

| Examples | AEG $\mu$eq/g | CEG $\mu$eq/g | Sum of EG $\mu$eq/g |
|---|---|---|---|
| Example 1 (Ex-1) | 101 | 74 | 175 |

(continued)

| Examples | AEG $\mu$eq/g | CEG $\mu$eq/g | Sum of EG $\mu$eq/g |
|---|---|---|---|
| Example 2 (Ex-2) | 55 | 15 | 70 |
| Example 3 (Ex-3) | 78 | 80 | 158 |
| Example 4 (Ex-4) | 37 | 32 | 69 |
| Comparative example 5 (Cex - 5) | 59 | 108 | 167 |
| Comparative example 6 (Cex - 6) | 19 | 63 | 82 |

**General procedure for the preparation of the compositions (C) :**

The polyamide resin prepared according to the procedure described above was fed to the first barrel of a ZSK-26 twin screw extruder comprising 12 zones via a loss in weight feeder. The barrel settings were in the range of 280-330°C and the resin was melted before zone 5. The wollastonite and the $TiO_2$ powder were fed at zone 5 through a side stuffer via a loss in weight feeder. The screw rate was 250 rpm. The extrudate was cooled and pelletized using conventional equipment. The results are summarized in Table 2, indicating each of the resin used, and the amount of each ingredient is given in weight %.

Each one of the compositions of examples 1-4 and comparative examples 5 - 6 were used to prepare discs of about 50 mm diameter with a thickness of about 1.6 mm.

Disks were placed in an oven at 260°C for ten minutes. Reflectance was measured with BKY-Gardner photo-spectrometer. The results are summarized in Table 2.

**Table 2**

| | (Ex-1) | (Ex-2) | (Ex-3) | (Ex-4) | (Cex-5) | (Cex-6) |
|---|---|---|---|---|---|---|
| **Polyamide** (%) | | | | | | |
| Example 1 (Ex-1) | 58 | | | | | |
| Example 2 (Ex-2) | | 58 | | | | |
| Example 3 (Ex-3) | | | 58 | | | |
| Example 4 (Ex-3) | | | | 58 | | |
| Comparative example 5 (Cex-5) | | | | | 58 | |
| Comparative example 6 (Cex-6) | | | | | | 58 |
| **Reinforcing filler** (%) | | | | | | |
| Wollastonite | 22 | 22 | 22 | 22 | 22 | 22 |
| **White pigment** (%) | | | | | | |
| Tipaque PC-3 | 20 | 20 | 20 | 20 | 20 | 20 |
| **Reflectivity measurements** at 450 nm (%) | | | | | | |
| After 10 min at 260°C | 62.1 | 74.0 | 59.7 | 69.7 | 46.5 | 52.8 |

The compositions of the present invention surprisingly show higher retention of reflectivity after exposure to air at 260°C for 10 min compared to comparative polyamides.

**Claims**

1.  An aromatic polyamide composition [composition (C)] comprising :

    (i) an aromatic polyamide polymer [polyamide (A)] comprising recurring units derived from

      - a carboxylic acid [acid component (AA)], comprising :

(a) at least one dicarboxylic acid or derivative thereof,
(b) optionally, at least one acid comprising only one reactive carboxylic acid group [acid (MA)], and
(c) adipic acid in an amount from 0 to 8 % moles, based on all the components of the acid component (AA),

- an amine [amine component (N)], comprising at least one diamine, and, optionally, at least one amine comprising only one reactive amine group [agent (MN)] ;
wherein in said polyamide (A) the number of amino end groups is equal to or in excess to the number of carboxyl end groups and wherein the number of amino end groups is equal to or less than 200 $\mu$eq/g and the number of carboxyl end groups is equal to or less than 100 $\mu$eq/g ;

(ii) at least one pigment selected from the group consisting of titanium dioxide ($TiO_2$) zinc disulfide ($ZnS_2$), zinc oxide (ZnO) and barium sulphate ($BaSO_4$) [pigment (P)] ; and
(iii) optionally, at least one reinforcing filler [filler (F)], different from pigment (P).

2. The composition (C) according to Claim 1, wherein the acid component (AA) comprises at least one phthalic acid [acid (PA)].

3. The composition (C) according to Claim 2, wherein the amount of acid (PA) is between 35 and 100 % moles, based on the all components of the acid component (AA).

4. The composition (C) according to Claim 2, wherein the acid (PA) is terephthalic acid (TA).

5. The composition (C) according to any one of Claims 1 to 4, wherein the amine component (N) comprises at least one aliphatic alkylene-diamine [amine (AL)].

6. The composition (C) according to Claim 5, wherein the amine (AL) is selected from the group consisting of 1,2-diaminoethane, 1,2-diaminopropane, propylene-1,3-diamine, 1,3-diaminobutane, 1,4-diaminobutane, 1,5-diaminopentane, 1,4-diamino-1,1-dimethylbutane, 1,4-diamino-1-ethylbutane, 1,4-diamino-1,2-dimethylbutane, 1,4-diamino-1,3-dimethylbutane, 1,4-diamino-1,4-dimethylbutane, 1,4-diamino-2,3-dimethylbutane, 1,2-diamino-1-butylethane, 1,6-diaminohexane, 1,7-diaminoheptane, 1,8-diamino-octane, 1,6-diamino-2,5-dimethylhexane, 1,6-diamino-2,4-dimethylhexane, 1,6-diamino-3,3-dimethylhexane, 1,6-diamino-2,2-dimethylhexane, 1,9-diaminononane, 1,6-diamino-2,2,4-trimethylhexane, 1,6-diamino-2,4,4-trimethylhexane, 1,7-diamino-2,3-dimethylheptane, 1,7-diamino-2,4-dimethylheptane, 1,7-diamino-2,5-dimethylheptane, 1,7-diamino-2,2-dimethylheptane, 1,10-diaminodecane, 1.8-diamino-1,3-dimethyloctane, 1,8-diamino-1,4-dimethyloctane, 1.8-diamino-2,4-dimethyloctane, 1,8-diamino-3,4-dimethyloctane, 1.8-diamino-4,5-dimethyloctane, 1.8-diamino-2,2-dimethyloctane, 1.8-diamino-3,3-dimethyloctane, 1,8-diamino-4,4-dimethyloctane, 1,6-diamino-2,4-diethylhexane, 1,9-diamino-5-methylnonane, 1,11-diaminoundecane and 1,12-diaminododecane.

7. The composition (C) according to any one of Claims 1 to 6, wherein the number of amino end groups is in excess to the number of carboxyl end groups in an amount between 1 and 200 peq/g.

8. The composition (C) according to any one of Claims 1 to 7, wherein the polyamide (A) has a total number of carboxyl and amino end groups equal to or less than 200 $\mu$eq/g

9. The composition (C) according to any one of Claims 1 to 8, wherein the total number of carboxyl and amino end groups is between 10 and 200 $\mu$eq/g.

10. The composition (C) according to any one of Claims 1 to 9, wherein the weight percent of the polyamide (A) is at least 30 wt. % based on the total weight of the composition (C).

11. The composition according to any one of Claims 1 to 10, wherein the weight percent of the reinforcing filler is at least 5 wt. % based on the total weight of the composition (C).

12. The composition according to any one of claims 1 to 11, wherein the weight percent of the pigment (P) is at least 1 wt. % based on the total weight of the composition (C).

13. The composition according to any one of claims 1 to 12, wherein the pigment (P) is titanium dioxide.

**14.** The composition according to any of the claims 1 to 13, wherein the titanium dioxide is in a particulate form.

**15.** An article comprising at least one component comprising the composition (C) according to any one of claims 1 to 14.

**16.** The article of claim 15 wherein said article is a light emission apparatus.

**17.** The article according to claim 16, wherein the light emission apparatus is a LED.

**18.** The article according to claim 17, wherein the LED comprises a reflector comprising the composition according to any of the claims 1 to 14.

**19.** Use of the composition (C) according to any of the claims 1 to 14 in a light emission apparatus.

**20.** Use according to claim 19, wherein said emission apparatus is a LED.

**Fig. 1**

**Fig. 2**

Europäisches
Patentamt

European
Patent Office

Office européen
des brevets

**EUROPEAN SEARCH REPORT**

Application Number

EP 11 18 8632

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/088507 A1 (OGASAWARA HIDETO [JP]) 2 April 2009 (2009-04-02) * claims 1-8; examples 1-3; paragraphs 1, 7 and 18; 21-22 and 24-25; 27; 34-38; 41-44; 48-50; 52-55; 75; 84 * ----- | 1-20 | INV. C08L77/06 C08G69/26 ADD. H01L33/48 H01L33/60 C08K3/22 C08K3/30 |

TECHNICAL FIELDS
SEARCHED      (IPC)

C08L
C08K
H01L
C08G

The present search report has been drawn up for all claims

| Place of search | Date of completion of the search | Examiner |
|---|---|---|
| Munich | 30 March 2012 | Okunowski, Françoise |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

.................................................................................

& : member of the same patent family, corresponding
  document

EPO FORM 1503 03.82 (P04C01)

**ANNEX TO THE EUROPEAN SEARCH REPORT
ON EUROPEAN PATENT APPLICATION NO.**

EP 11 18 8632

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2012

| Patent document cited in search report | Publication date | Patent family member(s) | | Publication date |
|---|---|---|---|---|
| US 2009088507 A1 | 02-04-2009 | CN | 101155878 A | 02-04-2008 |
| | | KR | 20070120196 A | 21-12-2007 |
| | | TW | I288768 B | 21-10-2007 |
| | | US | 2009088507 A1 | 02-04-2009 |
| | | WO | 2006112300 A1 | 26-10-2006 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1591461 B1

**Non-patent literature cited in the description**

- Additives for Plastics Handbook. John Murphy, 43-48